# EUROPEAN PATENT SPECIFICATION

(11) **EP 4 381 506 B1**
(45) Date of publication and mention of the grant of the patent: **04.12.2024**
(21) Application number: 22817440.5
(22) Date of filing: 26.10.2022
(51) Int. Cl.: G11C 29/44, G11C 29/00, G11C 29/12, G11C 29/24, G11C 29/28, G11C 29/02, G11C 29/26, G11C 29/32

(54) **REPAIR SHARING DIAGNOSTIC FOR MEMORIES WITH SERIAL REPAIR INTERFACES**
REPARATURTEILUNGSDIAGNOSE FÜR SPEICHER MIT SERIELLEN REPARATURSCHNITTSTELLEN
DIAGNOSTIC DE PARTAGE DE RÉPARATION POUR MÉMOIRES À INTERFACES DE RÉPARATION EN SÉRIE

(43) Date of publication of application: 12.06.2024
(73) Proprietor: Google LLC, Mountain View, CA 94043 (US)
(72) Inventor: PARASRAMPURIA, Mayank, Mountain View, CA 94043 (US); GOTTUMUKKALA, Rajesh, Mountain View, CA 94043 (US); PRADEEP, Wilson, Mountain View, CA 94043 (US)
(74) Representative: Marks & Clerk GST
(86) International application number: PCT/US2022/047841
(87) International publication number: WO 2024/091233

(56) References cited:
- US-A1- 2005 047 253
- US-A1- 2007 002 646
- US-A1- 2008 065 929
- US-A1- 2010 005 345
- US-A1- 2010 318 843
- US-A1- 2018 174 665

## Description

### BACKGROUND

This specification relates to devices having the capability to perform memory repair sharing, specifically in components that operate by a serial repair interface.

Memory repair is necessary to correct faults contained within memory structures, which can be present from manufacturing defects or can develop over time in operation. In some applications, a repair control system (RCS) is used to swap a determined faulty memory element with a suitable spare memory element. An example of a RCS could be a Built-in Signature Register (BISR). RCSs operate with a specific repair interface that controls chronologically how memory repairs are implemented across the serviced components. The repair interface used by any given device is dependent on many factors, and can differ between manufacturers and designers.

Repair interfaces are available in both parallel and serial formats. In a parallel interface, multiple spare memory elements can be exchanged directly for faulty elements by the RCS. This can be performed in various ways, to include a column based exchange, a row based exchange, or a combination of both. In a serial interface, there are multiple unique components to each memory that must be sequenced correctly by the RCS to effect a repair. This means that in a serial repair interface the RCS must usually effect a repair one memory structure at a time.

Repair sharing is a method in which similar memory structures are assigned the same RCS to effect repairs. This method assumes that if any one memory of a given set is determined to be faulty, that all memories of the group must be repaired regardless of their individual fault status. Repair sharing reduces the overall physical footprint of a RCS as the number of bits required to construct a system capable of scanning each individual memory may be prohibitively high from a functional or business perspective.

US 2018/174665 A1 describes an error injection system of a built-in self-repairable memory system renders the redundant spare columns of the repairable memory accessible to built-in self-test (BIST) read and write operations. US 2010/005345 A1 describes a communication interface device, system, method, and design structure for bit shadowing in a memory system. US 2010/318843 A1 describes a memory repair mechanism for memories clustered across multiple power domains and can be switched on and off independent of each other. US 2008/065929 A1 describes a system for repairing embedded memories on an
integrated circuit. US 2005/047253 A1 describes a BISR scheme which provides that fuse blocks are shared between memories to reduce hard-BISR implementation costs

### SUMMARY

This specification describes systems and techniques for implementing repair sharing in a serial self-repair interface according to independent claims 1, 5 and 9. Further preferred embodiments are defined in their dependent claims.

In a serial self-repair interface, there are sequential elements that need to be programmed via a serial interface (e.g. CLK, SI, EN, RST, or SO) which controls the selection of redundant elements. Repairing in this type of interface usually occurs one memory structure at a time, with the serial self-repair interface repairing each component of the memory structure in succession. Repair sharing in serial self-repair interfaces cannot follow the same process as parallel interfaces due to the need to sequence the repair of the individual components of each memory. However, there would still be benefits to introducing repair sharing to a serial self-repair interface. For example, these techniques can effectuate an overall footprint reduction and have additional benefits to the system. One example solution is a memory BISR sharing structure (MBSS). The MBSS can have multiple different functional areas, and, in one example, these areas include a shadow BISR chain, fault identification, fault diagnostic, and fault reinjection areas. Other implementations of a similar system may choose to have more, or less, functional areas.

The shadow BISR chain in this example identifies multiple memories for which repair sharing is to be performed. The process of selecting compatible memories can depend on multiple factors, to include processing type or capability, fault density, failure rate, or guidance from the manufacturer. Once suitable memories have been identified, one of the memories in the group is designated the 'main' memory, while all other memories are designated the 'shadow' memories. There is no limit to how many shadow memories can be designated in this manner.

Once suitable memories are grouped and designated, a scan-in signal is sent to the main memory. The MBSS in this example also sends the same scan-in signal to all of the shadow memories in parallel. In this example, a singular logical result, for example 'high' or 'low', is obtained for all of the shadow memories. This is obtained through the logic structure of the fault identification functional area, which in some examples includes a comparator. Additionally, this singular shadow memory scan-out is combined with the main memory scan-out through the fault reinjection functional area, in some examples through the use of a multiplexer, such that either a fault in serial repair RCS infrastructure, from the main memory or the overall shadow memory fault logic will trigger a failure for all memories, main and shadow. This signal is transmitted as one final 'scan-out' signal sent to the external repair infrastructure.

In this example, the MBSS is designed such that the external repair infrastructure needs to send only one input, and in return, receives only one output. One of the advantages of this process in this format is that it does not require any changes to the external serial repair infrastructure, as the external devices continue to 'see' their expected inputs and outputs for a single memory, in essence, one repair signal. The end result is that the MBSS can be utilized with a variety of serial repair infrastructures without changes to those devices.

Particular embodiments of the subject matter described in this specification can be implemented so as to realize one or more of the following advantages. Implementing the example system or a similar design allows an overall reduction in One-Time Programmable (OTP) memory. This results in a lower physical system footprint for repairing infrastructure. Additionally, the reduced repair chain length of this system can result in improved system boot up times or BISR reloading times. Also achieved is a reduction in the max chain length and the total BISR bits required. Finally, because the MBSS in this example is configured to work with existing serial repair interfaces, it does not require any changes to external hardware or software to implement.

The details of one or more embodiments of the subject matter of this specification are set forth in the accompanying drawings and the description below. Other features, aspects, and advantages of the subject matter will become apparent from the description, the drawings, and the claims.

### BRIEF DESCRIPTION OF THE DRAWINGS

FIG. 1 is a diagram of an system according to the invention.
FIG. 2A illustrates a memory structure that has one word and three addresses.
FIG. 2B illustrates a memory structure that has three words and one address.
FIG. 2C illustrates a memory that has two words and two addresses.
FIG. 3 is a detailed view of a comparator and fault detection system according to the invention.
FIG. 4 is an example method of how faults can be identified by the system.

### DETAILED DESCRIPTION

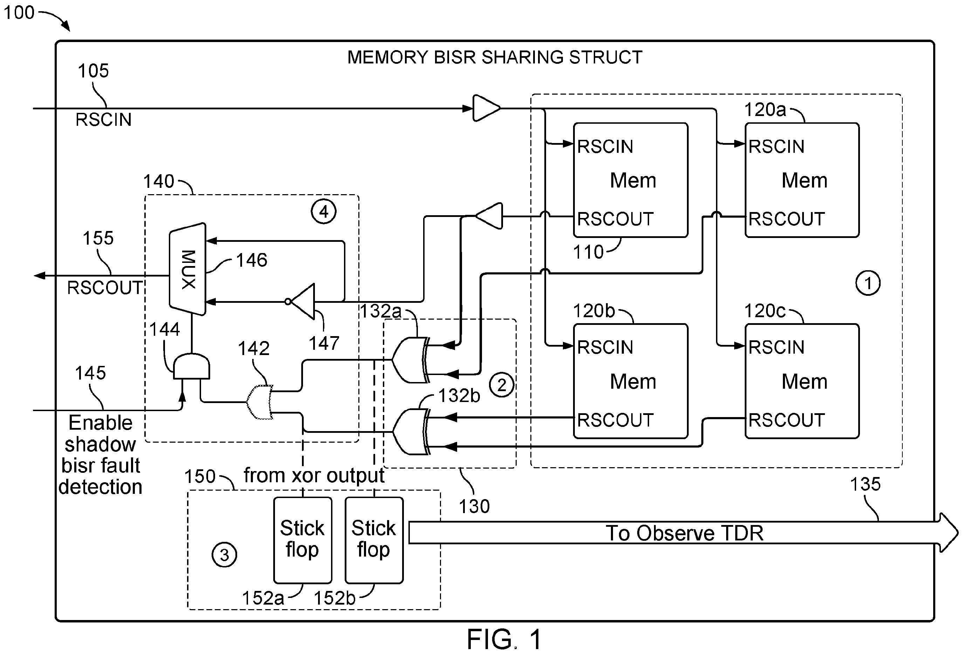

FIG. 1 is a diagram of a device 100 communicatively coupled to two, or more, memory devices 110 and 120a-c. The device 100 has a comparator 130, a fault reinjection system 140, and a fault detection system 150. The device 100 can be installed on or integrated into any appropriate computing device, which may be referred to as a host device.

The device 100 services multiple similar memory structures, for example 110 and 120a-c. Each of the memory structures can have serial self-repair interfaces. One of these memory structures 110 can act as a main memory while all other memories act as the shadow memories 120a-c. The device 100 is not limited to a certain number of memories, and can be configured to function with any given number of memory words or addresses. The device 100 can be designed such that it communicates with external memory test controllers which are allowed to view the contained virtual memories.

To repair the memories associated with the device 100, a scan-in (RSCIN) 105 is broadcast by using serial self-repair interfaces of the memories beginning with the main memory 110. The same RSCIN 105 from the the serial self-repair interface is also applied to each of the shadow memories 120a-c in parallel. The result of the scan for the main memory 110 is then scanned out to the fault reinjection system 140. The results of the scan for all memories, main 110 and shadow 120a-c, are scanned out to the comparator 130.

The comparator 130 includes a certain number (N) of exclusive OR (XOR) gates 132a-b that receive the scan out from the memories 110 and 120a-c. Upon receiving a mismatched scan out from the memories 110 or 120a-c, the comparator passes this high scan out to the fault reinjection system 140. The logic in the comparator is such that one XOR gate 132a-b is assigned to two memory structures, or two downstream XOR gates. There is no limit to how many XOR gates 132a-b are used in this fashion, provided that each XOR gate has two inputs and only one output. A mistmached scan out triggered by a faulty RCS path of memory will result in a high signal to its associated XOR gates. When a XOR gate receives differing input, one high and one low, from both of its associated memories, or downstream XOR gates, that XOR gate then passes a high signal to the next component, whether that is another XOR gate or the fault reinjection system 140. If the XOR gate receives a high or low signal from both of its associated memories or downstream XOR gates, the resulting output is low.

The comparator also sends any high scan-out received to the sticky flops 152a-b in the fault detection system 150. The fault detection system 150 can include multiple sticky flops 152a-b that activate a high signal upon sensing a mismatch indicated by the output of the comparator 130. This is then stored in the sticky flops 152a-b. The sticky flops 152a-b are then unloaded at the end of the test vector via a test data register (TDR) 135. The TDR 135 can then be used to indicate which memory triggered the failure and contains the faulty RCS infrastructure.

The fault reinjection system 140 includes a certain number (2N) of OR gates 142, an AND gate 144 that combines output from the OR gates 142 and shadow fault detection 145, and a multiplexer (MUX) 146. There is no limit to how many OR gates 142 are used in this fashion, provided that the ratio of OR gates 142 in the fault reinjection system 140 to the number of XOR gates 132a-b in the comparator 130 is two-to-one (2N/N), and each OR gate 142 has two inputs and only one output. Upon receiving a high signal from either of the downstream XOR gates 132a-b, or downstream OR gates, the OR gate 142 passes a high signal to the AND gate 144. The OR gate 142 will also pass a high signal to the next component in the event that both downstream XOR gates 132a-b, or OR gates, send high signals. The AND gate 144 receives input from the OR gate 142 and shadow fault detection 145. If shadow fault detection 145 is enabled, this input will be high. With shadow fault detection 145 disabled, this input is low. If both the OR gate 142 and shadow fault detection 145 send high signals, the AND gate 144 passes a high signal to the multiplexer 146. If the AND gate receives mixed signals, one high and one low, or two low signals, a low signal is passed to the multiplexer 146.

The fault reinjection feature is disabled in order to determine the fault status of only the main memory 110 RCS. Relatedly, the fault reinjection feature is enabled to check shadow memories 120a-c. Upon receiving a high signal from the AND gate 144 the multiplexer 146 selects the path with the inverter 147 and flips the scan out from the main chain and sends as (RSCOUT) 155 back to the serial self-repair interface. This inversion of main memory RSCOUT creates a bit flip in the data stream which gets identified as a fault in the shadow memory.

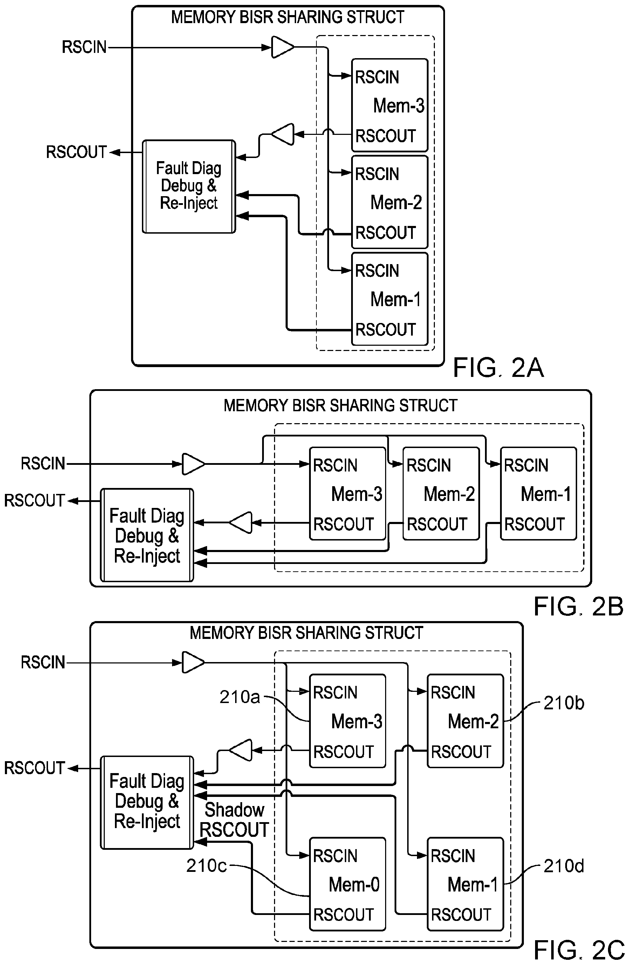

FIGs. 2A-2C illustrate several examples of memory structures of different word and address lengths that could be serviced by the device 100. These examples are not meant to be an exhaustive list. FIG. 2A illustrates a memory structure that has one word and three addresses. FIG. 2B illustrates a memory structure that has three words and one address. FIG. 2C illustrates a memory that has two words and two addresses. Referring to the example of FIG. 2C, in some implementations memories 210a and 210b together share the same word, as do memories 210c and 210d. Additionally, memories 210a and 210c together share the same address, as do memories 210b and 210d. The device 100 does not have a limit to how many different memory words or addresses can be serviced.

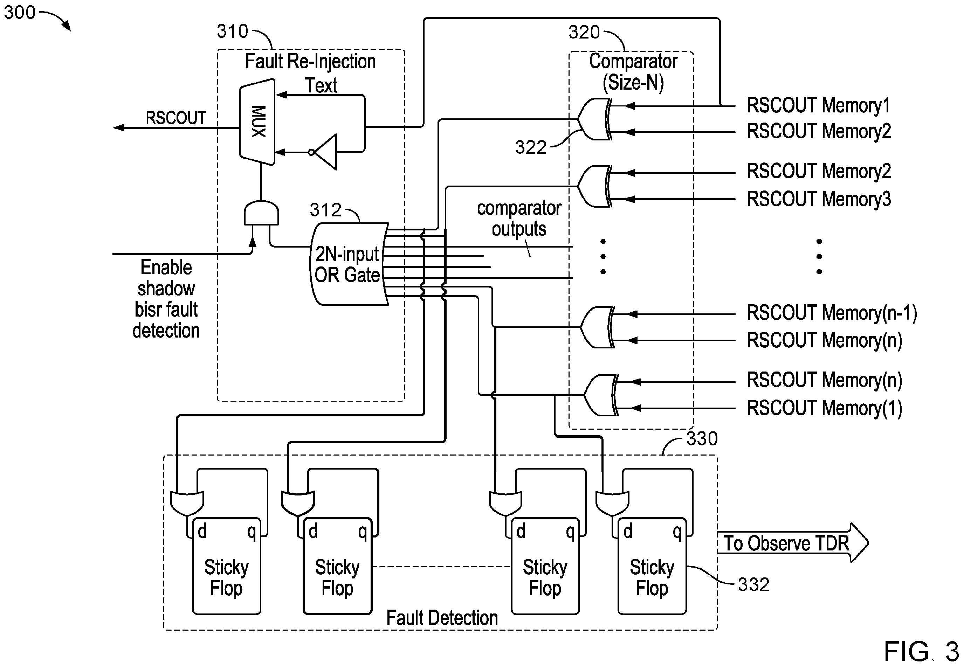

FIG. 3 illustrates a detailed view of a fault re-injection system 310, comparator 322, and fault detection system 330. The function of the major components of this system 300 is similar to the functions of system 100 as described for FIG. 1. This system 300 has been illustrated to show additional XOR gates 322 in the comparator 322, as well as additional sticky flops 332 in the fault detection system 330, for added clarity on the logical structure of the comparator and the integration of the fault detection system within the output of the comparator, respectively. In the fault re-injection system 310, the 2N OR gate 312 is a simplification of the logic needed for this representative example, including four XOR gates 322 servicing four memories. The 2N OR gate 312 could be constructed of any logic gates such that the final logical truth table would be such that the output is high for any high input received.

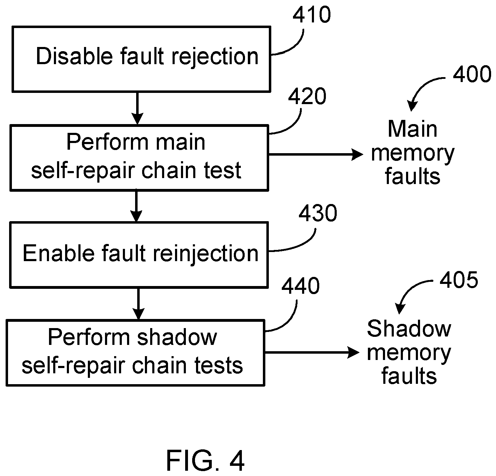

FIG. 4 illustrates an example process for checking faults on a component serviced by the system. Other examples of this process could use a different order for checking faults, or have more, or less, steps.

The first step in this example process disables fault reinjection (410). This is done such that the RCS fault status of the main memory can be determined, separate of the fault status of any of the shadow memories. In some embodiments, the fault reinjection must be disabled in order for the output of the multiplexer to be independent of the logical output of the shadow memories' comparator. By disabling fault reinjection in this example embodiment, the shadow memories' AND gate in the fault reinjection system will always receive one low input, and as such its output to the multiplexer will always be the data stream from main memory. In this way, only a fault with the main memory can cause a failure.

After disabling fault reinjection, a main self-repair chain test is then performed (420). This chain test outputs any faults associated with the main memory RCS only. These output faults are indicated as Main memory faults 400. In some embodiments, the fault status of the shadow memories RCS is ignored by the fault reinjection system in this case.

Following a main self-repair test, fault reinjection is enabled (430). This sends one high signal to the shadow memories' AND gate in the fault reinjection system. In some embodiments this is done such that when combined with a high signal from the shadow memories' comparator, the output of the AND gate to the multiplexer is a high signal. This ultimately triggers a bit flip via inverter 147 into the data stream in case of a mismatch flagged by the comparator resulting in fault indication.

One or more shadow self-repair chain tests are then performed (440). These chain tests output any faults that are associated with the one or more shadow memories. These output faults are indicated as Shadow memory faults 405. By performing this test after a successful main self-repair chain test (step 420), any faults can then be isolated to the shadow memories RCS.

Embodiments of the subject matter and the functional operations described in this specification can be implemented in digital electronic circuitry, in tangibly-embodied computer software or firmware, in computer hardware, including the structures disclosed in this specification and their structural equivalents, or in combinations of one or more of them. Embodiments of the subject matter described in this specification can be implemented as one or more computer programs, i.e., one or more modules of computer program instructions encoded on a tangible non-transitory storage medium for execution by, or to control the operation of, data processing apparatus. The computer storage medium can be a machine-readable storage device, a machine-readable storage substrate, a random or serial access memory device, or a combination of one or more of them. Alternatively or in addition, the program instructions can be encoded on an artificially-generated propagated signal, e.g., a machine-generated electrical, optical, or electromagnetic signal, that is generated to encode information for transmission to suitable receiver apparatus for execution by a data processing apparatus.

The term "data processing apparatus" refers to data processing hardware and encompasses all kinds of apparatus, devices, and machines for processing data, including by way of example a programmable processor, a computer, or multiple processors or computers. The apparatus can also be, or further include, special purpose logic circuitry, e.g., an FPGA (field programmable gate array) or an ASIC (application-specific integrated circuit). The apparatus can optionally include, in addition to hardware, code that creates an execution environment for computer programs, e.g., code that constitutes processor firmware, a protocol stack, a database management system, an operating system, or a combination of one or more of them.

A computer program which may also be referred to or described as a program, software, a software application, an app, a module, a software module, a script, or code) can be written in any form of programming language, including compiled or interpreted languages, or declarative or procedural languages, and it can be deployed in any form, including as a stand-alone program or as a module, component, subroutine, or other unit suitable for use in a computing environment. A program may, but need not, correspond to a file in a file system. A program can be stored in a portion of a file that holds other programs or data, e.g., one or more scripts stored in a markup language document, in a single file dedicated to the program in question, or in multiple coordinated files, e.g., files that store one or more modules, sub-programs, or portions of code. A computer program can be deployed to be executed on one computer or on multiple computers that are located at one site or distributed across multiple sites and interconnected by a data communication network.

For a system of one or more computers to be configured to perform particular operations or actions means that the system has installed on it software, firmware, hardware, or a combination of them that in operation cause the system to perform the operations or actions. For one or more computer programs to be configured to perform particular operations or actions means that the one or more programs include instructions that, when executed by data processing apparatus, cause the apparatus to perform the operations or actions.

The processes and logic flows described in this specification can be performed by one or more programmable computers executing one or more computer programs to perform functions by operating on input data and generating output. The processes and logic flows can also be performed by special purpose logic circuitry, e.g., an FPGA or an ASIC, or by a combination of special purpose logic circuitry and one or more programmed computers.

Computers suitable for the execution of a computer program can be based on general or special purpose microprocessors or both, or any other kind of central processing unit. Generally, a central processing unit will receive instructions and data from a read-only memory or a random access memory or both. The essential elements of a computer are a central processing unit for performing or executing instructions and one or more memory devices for storing instructions and data. The central processing unit and the memory can be supplemented by, or incorporated in, special purpose logic circuitry. Generally, a computer will also include, or be operatively coupled to receive data from or transfer data to, or both, one or more mass storage devices for storing data, e.g., magnetic, magneto-optical disks, or optical disks. However, a computer need not have such devices. Moreover, a computer can be embedded in another device, e.g., a mobile telephone, a personal digital assistant (PDA), a mobile audio or video player, a game console, a Global Positioning System (GPS) receiver, or a portable storage device, e.g., a universal serial bus (USB) flash drive, to name just a few.

Computer-readable media suitable for storing computer program instructions and data include all forms of non-volatile memory, media and memory devices, including by way of example semiconductor memory devices, e.g., EPROM, EEPROM, and flash memory devices; magnetic disks, e.g., internal hard disks or removable disks; magneto-optical disks; and CD-ROM and DVD-ROM disks.

While this specification contains many specific implementation details, these should not be construed as limitations on the scope of any invention or of what may be claimed, but rather as descriptions of features that may be specific to particular embodiments of particular inventions. Certain features that are described in this specification in the context of separate embodiments can also be implemented in combination in a single embodiment. Conversely, various features that are described in the context of a single embodiment can also be implemented in multiple embodiments separately or in any suitable subcombination. Moreover, although features may be described above as acting in certain combinations and even initially claimed as such, one or more features from a claimed combination can in some cases be excised from the combination, and the claimed combination may be directed to a subcombination or variation of a subcombination.

Similarly, while operations are depicted in the drawings in a particular order, this should not be understood as requiring that such operations be performed in the particular order shown or in sequential order, or that all illustrated operations be performed, to achieve desirable results. In certain circumstances, multitasking and parallel processing may be advantageous. Moreover, the separation of various system modules and components in the embodiments described above should not be understood as requiring such separation in all embodiments, and it should be understood that the described program components and systems can generally be integrated together in a single software product or packaged into multiple software products.

Particular embodiments of the subject matter have been described. Other embodiments are within the scope of the following claims.

## Claims

1. A device (100) comprising:
a plurality of memory devices each having a serial self-repair interface, one of the memory devices acting as a main memory (110) and all other memory devices acting as shadow memories (120a-c); and
a sharing structure comprising logic circuitry for inputting a same set of self-repair data to each of the plurality of memory devices and receiving self-repair outputs from the plurality of memory devices,
wherein the sharing structure comprises fault identification logic configured to detect mismatches between the self-repair outputs of the plurality of memory devices,
the fault identification logic comprises a plurality of XOR gates (132a-b) configured to compare self-repair outputs from respective pairs of the plurality of memory devices, and
the fault identification logic comprises an N-input OR gate (142) having a number of inputs equal to the number of XOR gates (132a-b).

2. The device of claim 1, wherein sharing structure is configured to perform a main self-repair chain test and a plurality of shadow self-repair chain tests.

3. The device of any one of claims 1-2, wherein the sharing structure comprises fault reinjection logic configured to flip the values of the self-repair outputs of the plurality of memory devices.

4. The device of any one of claims 1-3, wherein the device is configured to apply the same self-repair data to each of the plurality of memory devices having serial self-repair interfaces.

5. A method performed by a device (100) comprising a plurality of memory devices each having a serial self-repair interface, one of the memory devices acting as a main memory (110) and all other memory devices acting as shadow memories (120a-c), the method comprising:
inputting, by a sharing structure, a same set of self-repair data to each of the plurality of memory devices;
receiving, at the sharing structure, self-repair outputs from the plurality of memory devices; and
detecting, by fault identification logic of the sharing structure, mismatches between the self-repair outputs of the plurality of memory devices,
the fault identification logic comprises using a plurality of XOR gates (132a-b) configured to compare self-repair outputs from respective pairs of the plurality of memory devices, and
the fault identification logic comprises using an N-input OR gate (142) having a number of inputs equal to the number of XOR gates (132a-b).

6. The method of claim 5, wherein the sharing structure is configured for performing a main self-repair chain test and a plurality of shadow self-repair chain tests.

7. The method of any one of claims 5-6, wherein detecting mismatches between the self-repair outputs of the plurality of memory devices further comprises determining the fault status of individual memory devices.

8. The method of any one of claims 5-7, wherein detecting mismatches between the self-repair outputs of the plurality of memory devices comprises fault reinjection logic configured to flip the values of the self-repair outputs of the plurality of memory devices.

9. One or more non-transitory computer storage media encoded with computer program instructions that when executed by one or more computers cause the one or more computers to perform the method of any of claims 5 to 8.

## Patentansprüche

1. Vorrichtung (100), umfassend:
eine Vielzahl von Speichervorrichtungen mit jeweils einer seriellen Selbstreparaturschnittstelle, wobei eine der Speichervorrichtungen als Hauptspeicher (110) und alle anderen Speichervorrichtungen als Schattenspeicher (120a-c) fungieren; und
eine Sharing-Struktur, die eine Logikschaltung zum Eingeben eines gleichen Satzes von Selbstreparaturdaten in jede der Vielzahl von Speichervorrichtungen und zum Empfangen von Selbstreparaturausgaben von der Vielzahl von Speichervorrichtungen umfasst,
wobei die Sharing-Struktur eine Fehlererkennungslogik umfasst, die zum Erkennen von Diskrepanzen zwischen den Selbstreparaturausgängen der Vielzahl von Speichervorrichtungen konfiguriert ist,
die Fehlererkennungslogik eine Vielzahl von XOR-Gattern (132ab) umfasst, die zum Vergleichen von Selbstreparaturausgängen von entsprechenden Paaren der Vielzahl von Speichervorrichtungen konfiguriert sind, und
die Fehlererkennungslogik ein N-Eingangs-ODER-Gatter (142) umfasst, das eine Anzahl von Eingängen gleich der Anzahl von XOR-Gattern (132a-b) aufweist.

2. Vorrichtung nach Anspruch 1, wobei die Sharing-Struktur zum Durchführen eines Haupt-Selbstreparaturkettentests und eine Vielzahl von Schatten-Selbstreparaturkettentests konfiguriert ist.

3. Vorrichtung nach einem der Ansprüche 1-2, wobei die Sharing-Struktur eine Fehlerreinjektionslogik umfasst, die zum Umkehren der Werte der Selbstreparaturausgänge der Vielzahl von Speichervorrichtungen konfiguriert ist.

4. Vorrichtung nach einem der Ansprüche 1-3, wobei die Vorrichtung zum Anwenden der gleichen Selbstreparaturdaten auf jede der Vielzahl von Speichervorrichtungen konfiguriert ist, die serielle Selbstreparaturschnittstellen aufweisen.

5. Verfahren, das von einer Vorrichtung (100) durchgeführt wird, die eine Vielzahl von Speichervorrichtungen umfasst, die jeweils eine serielle Selbstreparaturschnittstelle aufweisen, wobei eine der Speichervorrichtungen als Hauptspeicher (110) und alle anderen Speichervorrichtungen als Schattenspeicher (120a-c) fungieren, wobei das Verfahren Folgendes umfasst:
Eingeben eines gleichen Satzes von Selbstreparaturdaten in jede der Vielzahl von Speichervorrichtungen durch eine Sharing-Struktur;
Empfangen von Selbstreparaturausgaben von der Vielzahl von Speichervorrichtungen an der Sharing-Struktur; und
Erkennen von Diskrepanzen zwischen den Selbstreparaturausgängen der Vielzahl von Speichervorrichtungen durch eine Fehlererkennungslogik der Sharing-Struktur,
wobei die Fehlererkennungslogik eine Vielzahl von XOR-Gattern (132a-b) umfasst, die zum Vergleichen von Selbstreparaturausgängen von entsprechenden Paaren der Vielzahl von Speichervorrichtungen konfiguriert sind, und
wobei die Fehlererkennungslogik ein N-Eingangs-ODER-Gatter (142) umfasst, das eine Anzahl von Eingängen gleich der Anzahl von XOR-Gattern (132a-b) aufweist.

6. Verfahren nach Anspruch 5, wobei die Sharing-Struktur zum Durchführen eines Haupt-Selbstreparaturkettentests und einer Vielzahl von Schatten-Selbstreparaturkettentests konfiguriert ist.

7. Verfahren nach einem der Ansprüche 5-6, wobei Erkennen von Diskrepanzen zwischen den Selbstreparaturausgängen der Vielzahl von Speichervorrichtungen ferner Bestimmen des Fehlerstatus von einzelnen Speichervorrichtungen umfasst.

8. Verfahren nach einem der Ansprüche 5-7, wobei Erkennen von Diskrepanzen zwischen den Selbstreparaturausgängen der Vielzahl von Speichervorrichtungen eine Fehlerreinjektionslogik umfasst, die zum Umkehren der Werte der Selbstreparaturausgänge der Vielzahl von Speichervorrichtungen konfiguriert ist.

9. Ein oder mehrere nichttransitorische Computerspeichermedien, die mit Computerprogrammanweisungen codiert sind, die bei Ausführung durch einen oder mehrere Computer den einen oder die mehreren Computer dazu veranlassen, das Verfahren nach einem der Ansprüche 5 bis 8 durchzuführen.

## Revendications

1. Dispositif (100) comprenant :
une pluralité de dispositifs de mémoire présentant chacun une interface d'auto-réparation en série, l'un des dispositifs de mémoire faisant office de mémoire principale (110) et tous les autres dispositifs de mémoire faisant office de mémoires fantômes (120a-c) ; et
une structure de partage comprenant des circuits logiques pour saisir un même ensemble de données d'auto-réparation dans chacun de la pluralité de dispositifs de mémoire et pour recevoir des sorties d'auto-réparation provenant de la pluralité de dispositifs de mémoire,
dans lequel la structure de partage comprend une logique d'identification de défauts configurée pour détecter des disparités entre les sorties d'auto-réparation de la pluralité de dispositifs de mémoires,
la logique d'identification de défauts comprend une pluralité de portes OU exclusif (132a-b) configurées pour comparer des sorties d'auto-réparation à partir de paires respectives de la pluralité de dispositifs de mémoire, et
la logique d'identification de défauts comprend une porte OU à N entrées (142) présentant un nombre d'entrées égal au nombre de portes OU exclusif (132a-b).

2. Dispositif selon la revendication 1, dans lequel la structure de partage est configurée pour réaliser un test principal de chaîne d'auto-réparation et une pluralité de tests fantômes de chaîne d'auto-réparation.

3. Dispositif selon l'une quelconque des revendications 1 et 2, dans lequel la structure de partage comprend une logique de réinjection de défauts configurée pour inverser les valeurs des sorties d'auto-réparation de la pluralité de dispositifs de mémoire.

4. Dispositif selon l'une quelconque des revendications 1 à 3, dans lequel le dispositif est configuré pour appliquer les mêmes données d'auto-réparation à chacun de la pluralité de dispositifs de mémoire présentant des interfaces d'auto-réparation en série.

5. Procédé mis en œuvre par un dispositif (100) comprenant une pluralité de dispositifs de mémoire présentant chacun une interface d'auto-réparation en série, l'un des dispositifs de mémoire faisant office de mémoire principale (110) et tous les autres dispositifs de mémoire faisant office de mémoires fantômes (120a-c), le procédé comprenant :
la saisie, par une structure de partage, d'un même ensemble de données d'auto-réparation dans chacun de la pluralité de dispositifs de mémoire ;
la réception, au niveau de la structure de partage, de sorties d'auto-réparation provenant de la pluralité de dispositifs de mémoire ; et
la détection, par une logique d'identification de défauts de la structure de partage, de disparités entre les sorties d'auto-réparation de la pluralité de dispositifs de mémoires,
la logique d'identification de défauts comprend l'utilisation d'une pluralité de portes OU exclusif (132a-b) configurées pour comparer des sorties d'auto-réparation à partir de paires respectives de la pluralité de dispositifs de mémoire, et
la logique d'identification de défauts comprend l'utilisation d'une porte OU à N entrées (142) présentant un nombre d'entrées égal au nombre de portes OU exclusif (132a-b).

6. Dispositif selon la revendication 5, dans lequel la structure de partage est configurée pour réaliser un test principal de chaîne d'auto-réparation et une pluralité de tests fantômes de chaîne d'auto-réparation.

7. Procédé selon l'une quelconque des revendications 5 à 6, dans lequel la détection de disparités entre les sorties d'auto-réparation de la pluralité de dispositifs de mémoire comprend également la détermination de l'état de défaut de dispositifs de mémoire individuels.

8. Procédé selon l'une quelconque des revendications 5 à 7, dans lequel la détection de disparités entre les sorties d'auto-réparation de la pluralité de dispositifs de mémoire comprend une logique de réinjection de défauts configurée pour inverser les valeurs des sorties d'auto-réparation de la pluralité de dispositifs de mémoire.

9. Un ou plusieurs supports de stockage informatique non transitoires codés avec des instructions de programme informatique qui, lorsqu'elles sont exécutées par un ou plusieurs ordinateurs, amènent les un ou plusieurs ordinateurs à mettre en œuvre le procédé selon l'une quelconque des revendications 5 à 8.
